(19) Europäisches Patentamt
European Patent Office
Office européen des brevets

(11) EP 2 937 912 B1

(12) **EUROPEAN PATENT SPECIFICATION**

(45) Date of publication and mention
of the grant of the patent:
**17.05.2017 Bulletin 2017/20**

(21) Application number: **13863746.7**

(22) Date of filing: **19.11.2013**

(51) Int Cl.:
*H01L 33/50* (2010.01)    *C09K 11/80* (2006.01)

(86) International application number:
**PCT/JP2013/081200**

(87) International publication number:
**WO 2014/097802 (26.06.2014 Gazette 2014/26)**

(54) **FLUORESCENT SUBSTANCE, LIGHT-EMITTING DEVICE, AND ILLUMINATOR**

FLUORESZIERENDE SUBSTANZ, LICHTEMITTIERENDE VORRICHTUNG UND BELEUCHTUNGSVORRICHTUNG

SUBSTANCE FLUORESCENTE, DISPOSITIF ÉLECTROLUMINESCENT ET ÉCLAIRAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.12.2012 JP 2012278891**

(43) Date of publication of application:
**28.10.2015 Bulletin 2015/44**

(73) Proprietor: **Denka Company Limited Tokyo 103-8338 (JP)**

(72) Inventors:
• **KOBAYASHI Keita**
**Omuta-city**
**Fukuoka 836-8510 (JP)**
• **FUSHII Yasuhito**
**Omuta-city**
**Fukuoka 836-8510 (JP)**

(74) Representative: **Gulde & Partner Patent- und Rechtsanwaltskanzlei mbB Wallstraße 58/59 10179 Berlin (DE)**

(56) References cited:
**WO-A1-2012/057330**    **JP-A- 2005 008 844**
**JP-A- 2011 119 768**

**Description**

Technical Field

The present invention relates to a fluorescent substance, a light-emitting device, and an illuminator.

Background Art

Patent Document 1 discloses a green-fluorescent substance made of LuAG:Ce.
Patent Document 2 discloses a colored and white light-emitting illuminator containing LuAG:Ce that converts blue or UV light to green light.

Citation List

Patent Literatures

[Patent Document 1] JP-A No. 2012-062444
[Patent Document 2] JP-T No. 2009-539219

Further JP2011119768 discloses illumination systems comprising LuAG:Ce phosphors.

Summary of Invention

Technical Problem

However, when green- and red-fluorescent substances were used, as mixed, for improvement of color rendering properties of a white light-emitting illuminator by preservation of red and green components, there emerged a new problem that one fluorescent substance absorbs the light emitted from the other fluorescent substance, resulting in deterioration of luminous efficiency.
Accordingly, an object of the present invention is to provide a fluorescent substance emitting a yellow light rich in red and green components, and a light-emitting device and an illuminator favorable in color rendering properties that comprises the fluorescent substance.

Solution to Problem

The inventors have found that it is possible to obtain a fluorescent substance emitting a yellow light rich in red and green components by specifying the composition of a fluorescent substance represented by General Formula LuAlONX:Ce and to obtain a light-emitting device and an illuminator favorable in color rendering properties by using the fluorescent substance and made the present invention.
The present invention relates to a fluorescent substance represented by General Formula: LuAlONX:Ce, wherein: X is at least one element selected from the group consisting of Bi, Tb, Pr, Gd, Se, Sm, Th, Ir, Sb, and As; 0.007 mass % $\le$ N $\le$ 5.0 mass %; Ce, Lu, and X satisfy 0.015 $\le$ (Ce+X)/Lu by molar ratio; Al, O, and N satisfy Al/(O+N) > 5/13 by molar ratio; and X>0.
In addition, the present invention relates to a light-emitting device comprising a light-emitting element and the fluorescent substance above and also to an illuminator comprising the light-emitting device above.

Advantageous Effects of Invention

The present invention provides a yellow light-emitting fluorescent substance rich in red and green components, and, a light-emitting device and an illuminator favorable in color rendering properties prepared by using the fluorescent substance.

Brief Description of Drawings

Figure 1 is a schematic view (region sectional view) explaining the light-emitting device in the second embodiment of the present invention.

Figures 2A and 2B are schematic views showing the configuration of the illuminator in the third embodiment of the present invention.

Description of Embodiments

Hereinafter, favorable embodiments of the present invention will be described.

The present invention relates to an oxynitride fluorescent substance comprising Lu, Al, O, N, Ce, and X that contains a great amount of cerium. It is the fluorescent substance above, wherein: X is at least one element selected from the group consisting of Bi, Tb, Pr, Gd, Se, Sm, Th, Ir, Sb, and As; 0.007 mass % $\leq$ N $\leq$ 5.0 mass %; Ce, X, and Lu satisfy 0.015 $\leq$ (Ce+X)/Lu by molar ratio; Al, O, and N satisfy Al/(O+N) > 5/13 by molar ratio; and X>0.

Another invention relates to a light-emitting device comprising the fluorescent substance and a light-emitting element. Yet another invention relates to an illuminator comprising the light-emitting device.

The first embodiment of the present invention relates to a fluorescent substance represented by the General Formula below. The fluorescent substance according to the present invention is represented by General Formula LuAlONX:Ce. It is the fluorescent substance above, wherein: X is at least one or two or more elements selected from Bi, Tb, Pr, Gd, Se, Sm, Th, Ir, Sb, and As; 0.007 mass % $\leq$ N $\leq$ 5.0 mass %; Ce, Lu, and X satisfy 0.015 $\leq$ (Ce+X)/Lu by molar ratio; Al, O, and N satisfy Al/(O+N) > 5/13 by molar ratio; and X>0.

Lu represents lutetium. The molar ratio of Lu is preferably 1.0 or more, more preferably 3.0 or less, and still more preferably 1.3 or more and 2.9 or less. Part or all of lutetium may be replaced with one or more elements selected from Y, Sc, La, Gd, and Sm.

Ce represents cerium. The molar ratio of Ce is preferably 0.1 or more, more preferably 2.0 or less, and still more preferably 0.18 or more and 1.50 or less. Part or all of cerium may be replaced with one or more elements selected from Pr, Nd, Eu, Tb, Dy, Ho, Er, Tm, Yb, Ba, and Mn.

Al represents aluminum. The molar ratio of Al is preferably 3.0 or more, more preferably 9.0 or less, and still more preferably 5.0 or more and 7.0 or less. Part or all of aluminum may be replaced with one or more elements selected from Ga, Si, and In.

X represents at least one or two or more elements selected from Bi, Tb, Pr, Gd, Se, Sm, Th, Ir, Sb, and As. Among the elements above, Gd and/or Tb is favorable. The molar ratio of X is preferably 0.005 or more, more preferably 0.5 or less, and still more preferably 0.01 or more and 0.40 or less.

The molar ratio of O is preferably 10.0 or more, more preferably 18.0 or less, and still more preferably 12.0 or more and 16.0 or less.

N represents nitrogen. The nitrogen content is 0.007 mass % or more and 5.0 mass % or less, and preferably 0.012% or more and 0.068% or less in the entire fluorescent substance. In addition, the molar ratio of N is preferably 0.005 or more, more preferably 0.05 or less, and still more preferably 0.007 or more and 0.044 or less.

Ce and Lu satisfy 0.015 $\leq$ (Ce+X)/Lu, preferably 0.06 $\leq$ (Ce+X)/Lu, more preferably Ce+X)/Lu $\leq$ 1.5, and still more preferably 0.068 $\leq$ (Ce+X)/Lu $\leq$ 1.31 by molar ratio.

Such a molar ratio leads to drastic increase of the chromaticity X, increase of the peak wavelength, enlargement of the half value width, increase of the rate of red fluorescence component (wavelength: 600 nm or more and 700 nm or less) and thus to long-wave length. It is because, when (Ce+X)/Lu by molar ratio and also the nitrogen content are increased, the rate of red component (wavelength: 600 nm or more and 700 nm or less) increases in the emission color of the fluorescent substance. When X>0, part of cerium is replaced with the other element described above, which leads to increase of the rate of red-fluorescence component and long-wave length. When the nitrogen content is excessively high, the emission intensity often deteriorates.

In addition, Al, O, and N satisfy Al/(O+N) > 5/13, preferably 0.385 $\leq$ Al/(O+N), more preferably Al/(O+N) $\leq$ 0.50, and still more preferably 0.391 $\leq$ Al/(O+N) $\leq$ 0.464 by molar ratio.

The nitrogen atoms in the fluorescent substance according to the present invention are present either or both in the crystal lattice and between the crystal lattices of the fluorescent substance. The fluorescent substance according to the present invention preferably essentially consist of Lu, Al, O, N, X, and Ce.

The fluorescent substance according to the present invention, which can emit visible light as it is excited more efficiently by a light having a wavelength in the range of 350 nm or more and 500 nm or less and emitted by a blue light-emitting element, permits production of a white LED that emits pure white light in combination with a blue LED, and thus the present invention is extremely useful industrially.

The fluorescent substance according to the present invention can be produced by mixing compounds practically containing Lu, Al, O, N, X, and Ce and firing the mixture. The firing is preferably carried out under pressurized nitrogen environment.

Hereinafter, an example of the production method for the fluorescent substance according to the present invention will be described.

The production method for the fluorescent substance according to the present invention preferably comprises a mixing step of mixing multiple raw materials consisting of compounds containing Lu, Al, O, N, X, and Ce and a firing step of firing the mixed raw material powder after the mixing step under a nitrogen atmosphere kept at a gage pressure of 0.001 MPa or more and 100 MPa or less and a temperature in the range of 1000°C or higher and 2400°C or lower.

Examples of the raw materials usable in the mixing step include 99% or more-purity compounds that are converted to oxides by decomposition at high temperature, such as hydroxide, carbonate, nitrate, halide, and oxalate, oxide having a purity of 99.9% or more, and nitride having a purity of 99.9% or more. Typical examples of the nitride include AlN and azide and those having a purity of 99.9% or more are preferable.

The machine used in the mixing step is, for example, a ball mill, a V-type mixer, or a stirring device.

The firing step is carried out, for example, as the mixed powder is kept at a temperature in the range of 1000°C or higher and 2400°C or lower and a pressure in the range of 0.001 MPa or more and 100 MPa or less for 1 hour or more and 100 hours or less.

The firing temperature is preferably 1500°C or higher and 2200°C or lower. The pressure of the atmosphere in the firing step is preferably 0.1 MPa or more, and more preferably 0.7 MPa or more and 70 MPa or less, and the highest allowable pressure is preferably 10 MPa or less, and more preferably 1 MPa or less. The firing period is preferably 1 hour or more and 30 hours or less, and more preferably 10 hours or more and 20 hours or less.

The atmosphere used during firing is, for example, a nitrogen element-containing atmosphere. The nitrogen element-containing atmosphere is, for example, nitrogen, ammonia, or the mixture thereof and it may contain an inert gas such as argon or helium additionally. The content of nitrogen, ammonia, or the mixture thereof is preferably 10 vol % or more, more preferably 50 vol % or more, still more preferably 80 vol %, and further more preferably 100 vol %. The nitrogen or the ammonia is most preferably a high-purity gas having a purity of 99.99% or more.

The peak wavelength in the excitation spectrum of the fluorescent substance according to the present invention is in the range of 300 nm to 500 nm (more favorably 350 nm to 500 nm). As the peak wavelength is in the range above, the fluorescent substance is excited efficiently by a light having a wavelength in the range above and emits a concentrated yellow light poor in green component and rich in red component and thus, it is favorable for use in a white LED higher in color rendering properties.

The light-emitting element for excitation of the fluorescent substance that emits a light having a wavelength of 300 nm to 500 nm (more favorably 350 nm to 500 nm) is preferably a light-emitting element of nitride semiconductor. Such a nitride semiconductor has an emission wavelength variable by the ratio of the constituent elements and, for example, a Ga-N-based semiconductor can control a peak of an emission wavelength in the range of 320 nm to 450 nm, while an In-Al-Ga-N-based semiconductor can control a peak of an emission wavelength in the range of 300 nm to 500 nm.

The light-emitting element of nitride semiconductor is, for example, a light-emitting element having a hetero structure or a double hetero structure, wherein the light-emitting layer is made of a compound represented by Composition Formula $In_xAl_yGa_{1-x-y}N$ (0<x, 0<y, x+y<1).

The second embodiment of the present invention relates to a light-emitting device comprising a light-emitting element and the fluorescent substance described above.

The light-emitting device according to the present invention preferably has a configuration wherein a transparent resin containing the fluorescent substance, as it is dispersed, is placed in the emission direction of the light-emitting element described above. The light-emitting element is preferably a blue light-emitting nitride semiconductor and a compound semiconductor that emits an ultraviolet to blue light may be used instead. The transparent resin is, for example, an epoxy resin, a polycarbonate, or a silicone rubber. The fluorescent substance in the light-emitting device may be made only of the fluorescent substance described above and it is also possible to make a whiter light-emitting device by using other fluorescent substances such as red- and green-emitting fluorescent substances additionally.

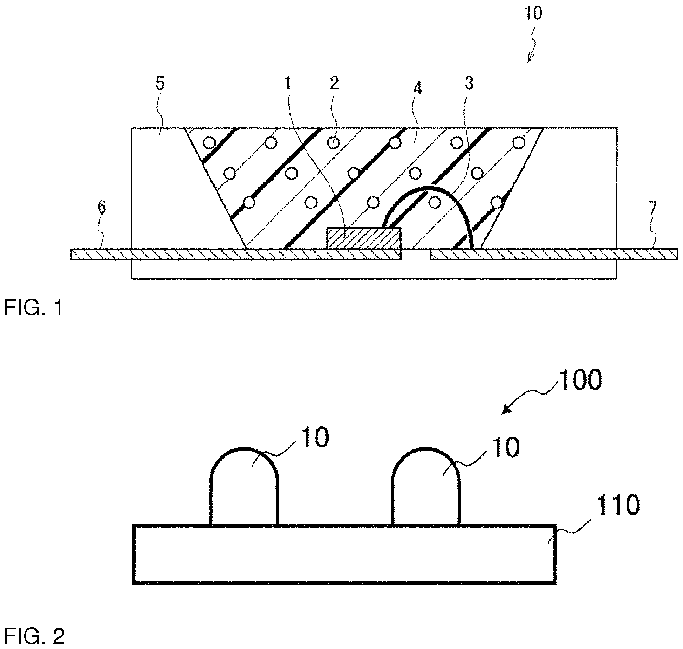

Figure 1 is a view showing an example of the configuration of the light-emitting device in the present embodiment, and the light-emitting device according to the present invention is not limited thereto. As shown in Figure 1, the light-emitting device 10 in the present embodiment has a light-emitting element 1 (for example, blue LED chip) and fluorescent substances 2 placed on the light-emitting face of the light-emitting element and part or all of the fluorescent substances 2 are made of the fluorescent substance according to the present invention described above.

Examples of the light-emitting element 1 for use include various LEDs such as UV light-emitting diodes (UV-LEDs) and blue light-emitting diodes (blue LEDs), fluorescent lamps, laser diodes (LD), and the like. LEDs are desirable. Although the fluorescent substance according to the present invention described above may be used solely as the fluorescent substance 2, red, orange, yellow, green, blue, and other light-emitting fluorescent substances may be used in combination. It is thus possible to adjust the color of the light emitted from the light-emitting device.

The light-emitting device 10 of the present embodiment has a light-emitting element 1 mounted on a conductive terminal (lead frame) 6 and the light-emitting element 1 is sealed on the conductive terminal 6 with a sealing resin 4 carrying dispersed fluorescent substances 2 in a container (frame) 5. The light-emitting element 1 is connected to another conductive terminal (lead frame) 7 via a conductive wire (bonding wire) 3.

The light-emitting device may be enclosed (molded) with a visible light-transmitting resin, if needed. Examples of the visible light-transmitting resins include epoxy resins, urethane resins, silicone resins, and the like. The visible light-transmitting resin may contain, as needed, additives such as viscosity improvers, dispersing agents, and ultraviolet absorbents.

The light-emitting device may have, for example, a cannonball-, chip-, or multi-segment-type external shape.

The light-emitting device 10 of the present embodiment emits an excitation light having a wavelength of 350 to 500 nm from the light-emitting element 1, and the fluorescent substances 2 described above are irradiated with the excitation light. By irradiation of the excitation light, the compounds of the fluorescent substances 2 emit a concentrated yellow light (favorably having a peak wavelength of 540 to 560 nm) poor in green component and rich in red component. The compound according to the present invention used in the light-emitting device 10 of the present embodiment has favorable color rendering index (Ra) and external quantum efficiency. Favorably, it has a color rendering properties index (Ra) of 70.5 or more and an external quantum efficiency of 40% or more. In addition, it favorably has a chromaticity X of 0.38 or more (favorably, a chromaticity X of 0.38 to 0.460). In this way, the light-emitting device 10 of the present embodiment can emit a yellow light rich both in red and green components and shows better color rendering properties.

The third embodiment of another invention relates to an illuminator comprising a light-emitting device comprising the fluorescent substance according to the present invention. The illuminator may comprise one or more light-emitting devices containing the fluorescent substance according to the present invention. The number and the configuration of the light-emitting devices integrated may be selected arbitrarily, for example, according to the size and the illuminance of the illuminator.

The illuminator above, for example, has a configuration in which the AC input terminal of a lighting module is connected to commercial AC power supply and one or more light-emitting devices are connected in series or in parallel to the DC output terminals of the lighting module, although the configuration is not particularly limited thereto.

Examples of the types of the illuminator include, but are not particularly limited to, electric lamps, fluorescent lamps, down lights, plane lighting units.

In the illuminator 100 of the present embodiment shown in Figure 2, two or more light-emitting devices 10 enclosed by a visible light-transmitting resin are mounted on a circuit board 110.

The circuit board 110 has a drive circuit formed for driving the light-emitting devices 10.

The number of the light-emitting devices 10 and the configuration of the light-emitting devices 10 on the circuit board 110 are arbitrary according to the use of the illuminator 100. For example if the illuminator 100 is used as a linearly-emitting light source, multiple light-emitting devices 10 are placed linearly; alternatively if the illuminator 100 is used as a planar light-emitting device, multiple light-emitting devices 10 are placed two-dimensionally; and yet alternatively if the illuminator 100 is used as a point light source, one light-emitting device 10 is used. In this way, the illuminator 100 can emit a yellow light rich both in red and green light components and show favorable color rendering properties.

Examples

Hereinafter, Examples of the present invention will be described in detail with reference to Tables 1 and 2, as compared with Comparative Examples.

[Table 1]

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| Fluorescent substance | Lu (molar ratio) | | 1.30 | 2.20 | 2.62 | 1.30 | 2.20 | 2.62 | 2.81 | 2.42 | 2.81 | 2.77 |
| | X (molar ratio) | Gd | 0.20 | 0.20 | 0.20 | 0.20 | 0.20 | 0.20 | 0.01 | 0.40 | 0.01 | |
| | | Tb | | | | | | | | | | 0.05 |
| | Ce (molar ratio) | | 1.50 | 0.60 | 0.18 | 1.50 | 0.60 | 0.18 | 0.18 | 0.18 | 0.18 | 0.18 |
| | Al (molar ratio) | | 7.00 | 7.00 | 7.00 | 5.00 | 5.00 | 5.00 | 5.00 | 5.00 | 5.00 | 5.00 |
| | O (molar ratio) | | 15.75 | 15.30 | 15.09 | 12.75 | 12.30 | 12.09 | 12.09 | 12.09 | 12.09 | 12.10 |
| | N (molar ratio) | | 0.044 | 0.024 | 0.009 | 0.035 | 0.021 | 0.008 | 0.007 | 0.010 | 0.007 | 0.008 |
| | Nitrogen content (mass %) | | 0.068% | 0.036% | 0.013% | 0.061% | 0.035% | 0.013% | 0.012% | 0.017% | 0.012% | 0.013% |
| | (Ce+X)/Lu (molar ratio) | | 1.308 | 0.364 | 0.145 | 1.308 | 0.364 | 0.145 | 0.068 | 0.240 | 0.068 | 0.083 |
| | Al/(O+N) (molar ratio) | | 0.443 | 0.457 | 0.464 | 0.391 | 0.406 | 0.413 | 0.413 | 0.413 | 0.413 | 0.413 |
| Raw material composition of fluorescent substance | $Lu_2O_3$ (mass %) | | 28.43 | 46.86 | 55.14 | 32.01 | 52.60 | 61.81 | 66.03 | 57.33 | 66.01 | 65.09 |
| | $Al_2O_3$ (mass %) | | 39.22 | 38.20 | 37.75 | 31.55 | 30.63 | 30.22 | 30.10 | 30.35 | 30.10 | 30.10 |
| | $CeO_2$ (mass %) | | 28.37 | 11.06 | 3.28 | 31.95 | 12.41 | 3.67 | 3.66 | 3.69 | 3.66 | 3.66 |
| | $Gd_2O_3$ (mass %) | | 3.98 | 3.88 | 3.83 | 4.49 | 4.36 | 4.30 | 0.21 | 8.63 | – | – |
| | $Tb_4O_7$ (mass %) | | – | – | – | – | – | – | – | – | 0.23 | 1.15 |
| Firing environments | | | Nitrogen 0.7MPa | Nitrogen 0.7MPa | Nitrogen 0.7MPa | Nitrogen 0.7MPa | Nitrogen 0.7MPa | Nitrogen 0.7MPa | Nitrogen 0.7MPa | Nitrogen 0.7MPa | Nitrogen 0.7MPa | Nitrogen 0.7MPa |
| External quantum efficiency (%) | | | 41.9 | 54.8 | 68.3 | 41.9 | 51.6 | 60.9 | 58.4 | 61.5 | 61.3 | 61.3 |
| Chromaticity X | | | 0.456 | 0.428 | 0.397 | 0.455 | 0.412 | 0.393 | 0.390 | 0.402 | 0.388 | 0.391 |
| Peak wavelength (nm) | | | 557.4 | 552.1 | 549.3 | 556.4 | 551.6 | 549.1 | 548.5 | 550.2 | 545.3 | 547.2 |
| LED color rendering index (Ra) | | | 77 | 74.1 | 71.4 | 77 | 72.9 | 70.7 | 70.6 | 71.7 | 70.6 | 70.6 |

[0032]

[Table 2]

| | | Comparative Example | | | | | | | | |
|---|---|---|---|---|---|---|---|---|---|---|
| | | 1 | 2 | 3 | 4 | 5 | 6 | 7 | 8 | 9 |
| Fluorescent substance | Lu (molar ratio) | 2.82 | 2.96 | 2.96 | 2.82 | 2.82 | 1.50 | 2.40 | 2.82 | 2.82 |
| | X (molar ratio) Gd | | | | 0.20 | 0.20 | 0.20 | 0.20 | 0.20 | |
| | X (molar ratio) Tb | | | | | | | | | |
| | Ce (molar ratio) | 0.18 | 0.04 | 0.04 | 0.18 | 0.18 | 1.50 | 0.60 | 0.18 | 0.18 |
| | Al (molar ratio) | 5.00 | 5.00 | 7.00 | 5.00 | 7.00 | 4.00 | 4.00 | 4.00 | 4.00 |
| | O (molar ratio) | 12.09 | 12.02 | 15.02 | 12.39 | 15.39 | 11.55 | 11.10 | 10.89 | 10.59 |
| | N (molar ratio) | 0.006 | 0.004 | 0.005 | 0.002 | 0.001 | 0.031 | 0.022 | 0.013 | 0.011 |
| | Nitrogen content (mass %) | 0.010% | 0.007% | 0.007% | 0.003% | 0.001% | 0.054% | 0.038% | 0.022% | 0.019% |
| | (Ce+X)/Lu (molar ratio) | 0.064 | 0.014 | 0.014 | 0.135 | 0.135 | 1.133 | 0.333 | 0.135 | 0.064 |
| | Al/(O+N) (molar ratio) | 0.413 | 0.416 | 0.466 | 0.403 | 0.455 | 0.345 | 0.360 | 0.367 | 0.377 |
| Raw material composition of fluorescent substance | $Lu_2O_3$ (mass %) | 66.25 | 69.23 | 61.82 | 63.53 | 56.95 | 37.46 | 58.17 | 67.42 | 70.49 |
| | $Al_2O_3$ (mass %) | 30.10 | 29.96 | 37.46 | 28.86 | 36.22 | 25.59 | 24.84 | 24.50 | 25.62 |
| | $CeO_2$ (mass %) | 3.66 | 0.81 | 0.72 | 3.51 | 3.14 | 32.40 | 12.58 | 3.72 | 3.89 |
| | $Gd_2O_3$ (mass %) | – | – | – | 4.10 | 3.68 | 4.55 | 4.42 | 4.36 | – |
| | $Tb_4O_7$ (mass %) | – | – | – | – | – | – | – | – | – |
| Firing environments | | Nitrogen 0.7MPa | Nitrogen 0.7MPa | Nitrogen 0.7MPa | Vacuum | Vacuum | Nitrogen 0.7MPa | Nitrogen 0.7MPa | Nitrogen 0.7MPa | Nitrogen 0.7MPa |
| External quantum efficiency (%) | | 62.0 | 65.7 | 72.4 | 62.1 | 70.3 | 33.6 | 35.2 | 37.6 | 39.5 |
| Chromaticity X | | 0.386 | 0.380 | 0.382 | 0.374 | 0.376 | 0.414 | 0.402 | 0.390 | 0.382 |
| Peak wavelength (nm) | | 544.7 | 543.8 | 543.7 | 541.3 | 542.6 | 550.8 | 550.1 | 548.3 | 543.9 |
| LED color rendering index (Ra) | | 70.3 | 69.5 | 69.7 | 68.9 | 69.3 | 72.9 | 71.4 | 70.5 | 69.7 |

[Example 1]

As shown in Table 1, the fluorescent substance of Example 1 is a fluorescent substance containing Lu, Al, O, N, Ce, and X, wherein X is Gd, the nitrogen content is 0.068 mass %, Ce, X, and Lu satisfy (Ce+X)/Lu = 1.308 (molar ratio), and Al/(O+N) is 0.443. The fluorescent substances of Example 1 and also of the Examples and Comparative Examples described below have molar ratios different from each other, as the composition of the raw material was altered. The values of the fluorescent substances shown in Tables 1 and 2 are those when raw materials were blended and they are also target values.

<Values of Lu, Y, Ce, Al, O, and N obtained by composition analysis and nitrogen content>

The values of the fluorescent substances in Tables 1 and 2 were determined by fusing the mixed raw material powder by alkali fusion method and analyzing the composition with an ICP emission spectrophotometer (CIROS-120, manufactured by Rigaku Corporation). The nitrogen contents (mass %) in Tables 1 and 2 were determined by an oxygen-nitrogen analyzer (EMGA-920 manufactured by HORIBA Ltd.). The nitrogen content satisfactory in Examples is 0.007 mass % or more.

Results obtained for the external quantum efficiency (unit: %), chromaticity X, and peak wavelength (unit: nm) of the fluorescent substance of Example 1 are summarized in Table 1.

<External quantum efficiency>

The external quantum efficiency was determined by a spectrophotometer (MCPD-7000, manufactured by Otsuka Electronics Co., Ltd.) and calculated in the following procedure: The fluorescent substance of Example 1 was filled into a concave cell with the surface flattened and an integrating sphere was connected thereto. A monochromatic light having a wavelength of 455 nm, which was isolated from the light of a light source (Xe lamp), was introduced into the integrating sphere via an optical fiber. The monochromatic light was irradiated to the sample of the fluorescent substance of Example 1 as excitation source and the fluorescence spectrum from the sample was determined.

A standard reflector having a reflectance of 99% (Spectralon manufactured by Labsphere) was placed in the sample unit and the spectrum of the excitation light having a wavelength of 455 nm was determined. The excitation light photon number (Qex) was then calculated from the spectrum in the wavelength range of 450 to 465 nm.

A fluorescent substance was placed in the sample unit, and the reflected excitation light photon number (Qref) and the fluorescence photon number (Qem) were calculated from the spectral data obtained. The reflected excitation light photon number was calculated in the wavelength range identical with that for the excitation light photon number and the fluorescence photon number was calculated in the wavelength range of 465 to 800 nm. The external quantum efficiency was calculated according to the following Formula:

$$\text{External quantum efficiency} = (Qem/Qex) \times 100$$

The external quantum efficiency satisfactory in Examples was 40% or more.

<Chromaticity X (CIEx)>

In this test, the chromaticity X, which is a value of CIE1931 (XYZ colorimetric system), was determined by a spectrophotometer (MCPD-7000 manufactured by Otsuka Electronics Co., Ltd.). The chromaticity X (CIEx) was determined by measuring the fluorescence spectrum of the entire luminous flux of the fluorescent light obtained after excitation at 455 nm on an instantaneous multi-measurement system (MCPD-7000, manufactured by Otsuka Electronics Co., Ltd.), using an integrating sphere. The chromaticity X was determined according to a reference literature: "Kazuaki Ohkubo et al., "Absolute Fluorescent Quantum Efficiency of NBS Phosphor Standard Samples," Journal of the Illuminating Engineering Institute of Japan, 83, 2, pp87-93, 1999".

The chromaticity X satisfactory in Examples is 0.387 or more.

<Fluorescence spectrum>

In this test, the peak wavelength was determined by a spectrophotometer (MCPD-7000 manufactured by Otsuka Electronics Co., Ltd.). The sample fluorescent substance was filled into a concave cell with the surface flattened and an integrating sphere was connected thereto. A monochromatic light (blue light) having a wavelength of 455 nm isolated from the light of a light source (Xe lamp) was introduced into the integrating sphere via an optical fiber. The fluorescent substance sample was irradiated with the monochromatic light as excitation source and the fluorescence spectrum of the sample was determined. The peak wavelength was determined from the fluorescence spectrum obtained.

The peak wavelength satisfactory in Examples is 545.0 nm or more.

<Color rendering index (Ra)>

In this test, the color rendering index (Ra) was determined in the following manner:

10 g of a fluorescent substance was added to 100 g of water with 1.0 g of an epoxysilane coupling agent (KBE402 produced by Shin-Etsu Silicones Co., Ltd.) and the mixture was left, as it was stirred, for one day. Then after filtration and drying, a suitable amount of the fluorescent substance above treated with a silane-coupling agent was blended with 10 g of an epoxy resin (NLD-SL-2101 produced by Sanyu Rec Co., Ltd.); the mixture was potted on an blue LED element having an emission wavelength of 460 nm; and after evacuation, the resin was hardened thermally at 110°C, to give a surface-mounting-type LED. The light emitted when 10 mA of current was applied to the surface-mounting-type LED obtained was determined and the color rendering index (Ra) was determined therefrom.

The color rendering index (Ra) satisfactory in Examples is 70.5 or more.

As shown in Table 1, the fluorescent substance of Example 1 showed favorable values in external quantum efficiency, chromaticity X, peak wavelength, and color rendering index (Ra).

The method for preparing the fluorescent substance of Example 1 will be described below.

The fluorescent substance of Example 1 was prepared by a method consisting of a mixing step of mixing multiple raw materials of compounds containing Lu, Al, O, N, and Ce and a firing step of firing the mixed raw material powder after the mixing step under a nitrogen atmosphere at a gauge pressure of 0.001 MPa or more and 100 MPa or less and in a temperature range of 1000°C or higher and 2400°C or lower.

<Mixing step>

In the mixing step, 28.43 mass % of $Lu_2O_3$ (produced by Wako Pure Chemical Industries, Ltd.), 28.37 mass % of $CeO_2$ (produced by Wako Pure Chemical Industries, Ltd., Wako special grade), 39.22 mass % of $Al_2O_3$ (produced by Taimei Chemicals Co., Ltd., TM-DAR grade), and 3.98 mass % of $Gd_2O_3$ (produced by Wako Pure Chemical Industries, Ltd., Wako special grade) were blended, to give 1 kg of a raw material mixture. The molar ratio of the elements blended, i.e., Lu: Gd: Ce: Al, was 1.30: 0.20: 1.50: 7.00.

The raw material mixture was mixed in a super mixer of Kawata Mfg. Co., Ltd. and sieved through a nylon sieve having an opening of 850 μm, to give a raw powder.

<Firing step>

50 g of the raw powder was filled into a capped cylindrical boron nitride container having an internal diameter of 8 cm and an internal height of 8 cm (N-1 grade, manufactured by DENKI KAGAKU KOGYO KABUSHIKI KAISHA) and the container was placed in a top-capped graphite box having an internal size of 100 cm×50 cm×13 cm (height). The graphite box had holes having a diameter of 20 mm on the side wall, four along the long side and four along the short side. It had additionally a hole having a diameter of 50 mm at the center of the bottom and an exhaust gas pipe was installed under the hole for discharge of the environmental gas during firing. The raw powder was heated in a carbon-heater electric furnace at 1700°C under a nitrogen atmosphere pressurized at 0.7 MPa for 15 hours and the powder obtained was cooled gradually to room temperature. The fired product was pulverized in a mortar and the powder passing a sieve having an opening of 250 μm was collected.

[Example 2]

The fluorescent substance of Example 2, which contains Lu in a greater amount and Ce and nitrogen in smaller amounts than that of Example 1, was prepared similarly to Example 1, except that the raw material composition described in Table 1 was modified.

[Example 3]

The fluorescent substance of Example 3, which contains Lu in a further greater amount, Ce in a further smaller amount, and nitrogen in a smaller amount than that of Example 1, was prepared similarly to Example 1, except that the raw material composition described in Table 1 was modified.

[Example 4]

The fluorescent substance of Example 4, which contains Al, oxygen, and nitrogen in smaller amounts than that of Example 1, was prepared similarly to Example 1, except that the raw material composition described in Table 1 was modified.

[Example 5]

The fluorescent substance of Example 5, which contains Al and oxygen in smaller amounts than that of Example 2, was prepared similarly to Example 2, except that the raw material composition described in Table 1 was modified.

[Example 6]

The fluorescent substance of Example 6, which contains Al and oxygen in smaller amounts than that of Example 3, was prepared similarly to Example 3, except that the raw material composition described in Table 1 was modified.

[Example 7]

The fluorescent substance of Example 7, which contains Gd in a smaller amount than that of Example 6, was prepared similarly to Example 6, except that the raw material composition described in Table 1 was modified.

[Example 8]

The fluorescent substance of Example 8, which contains Gd in a greater amount than that of Example 6, was prepared similarly to Example 6, except that the raw material composition described in Table 1 was modified.

[Example 9]

The fluorescent substance of Example 9, wherein Gd in Example 7 was replaced with Tb, was prepared similarly to Example 7, except that the raw material composition described in Table 1 was modified.

[Example 10]

The fluorescent substance of Example 10, which contains Tb in a greater amount than that of Example 9, was prepared similarly to Example 9, except that the raw material composition described in Table 1 was modified.

The fluorescent substances of Examples 1 to 10 had a LED color rendering index (Ra) of 70.5 or more and an external quantum efficiency of 40% or more. They has a LED color rendering index (Ra) in the range of 70.6 to 77, an external quantum efficiency in the range of 41.9 to 68.3%, and a chromaticity X in the range of 0.388 to 0.456. In addition, they had a peak wavelength (nm) in the range of 545.3 to 557.4 nm.

Hereinafter, Comparative Examples will be described with reference to Table 2.

As shown in Table 2, in Comparative Examples 1 to 9, the molar ratios of the elements in the fluorescent substance were altered by modification of the raw material composition of the fluorescent substance.

In Comparative Example 1, part of Ce was not replaced with X (Gd, Tb), as compared with Examples 6 to 10. The fluorescent substance of Comparative Example 1 was not satisfactory all in chromaticity X, peak wavelength, and color rendering index (Ra).

In Comparative Examples 2 and 3, part of Ce was not replaced with X (Gd, Tb) in a manner similar to Comparative Example 1 and additionally the value of (Ce+X)/Lu was changed to 0.014. The fluorescent substances of Comparative Examples 2 and 3 were not satisfactory all in chromaticity X, peak wavelength, and color rendering index (Ra).

Comparative Examples 4 and 5 were carried out under vacuum, replacing the nitrogen atmosphere used in the firing step of other Examples and Comparative Examples. In Comparative Examples 4 and 5, the fluorescent substances had a smaller nitrogen content and thus were not satisfactory all in chromaticity X, peak wavelength, and color rendering index (Ra).

In Comparative Examples 6 to 8, where the value of Al/(O+N) is lower, the fluorescent substance was not satisfactory in external quantum efficiency.

In Comparative Example 9, where the values of (Ce+X)/Lu, Al, and Al/(O+N) were lower, the fluorescent substance was not satisfactory all in external quantum efficiency, chromaticity X, peak wavelength, and color rendering index (Ra).

[Example 11]

The invention of Example 11, which relates to a light-emitting device, comprises a fluorescent substance of Examples or Comparative Examples and a light-emitting element, as shown in Figure 1. The light-emitting device, which emits white light, was prepared by installing a blue LED chip 1 on the bottom of a container 5, as it is connected to a conductive terminal 6, connecting the blue LED chip 1 to another conductive terminal 7 via wire 3, and then, hardening the fluorescent substance 2 and an epoxy resin as sealing resin 4 under heat.

It is a surface-mounting-type LED described in the section of determination of color rendering index (Ra) described above.

The light-emitting device of Example 11 showed favorable advantageous effects, as shown by Examples 1 to 10 of Table 1.

[Example 12]

The invention of Example 12, which relates to an illuminator, is an electric-lamp illuminator containing the light-emitting device of Example 11, although it is not shown in Figure. The illuminator showed the advantageous effects shown in Table 1, when one of the fluorescent substances of Example 1 to 10 was used.

Reference Signs List

| | |
|---|---|
| 1: | Blue LED chip |
| 2: | Fluorescent substance |
| 3: | Wire |
| 4: | Sealing resin |
| 5: | Container |
| 6: | Conductive terminal |
| 7: | Other conductive terminal |
| 10: | Light-emitting device |
| 100: | Illuminator |
| 110: | Circuit board |

**Claims**

1. A fluorescent substance represented by General Formula: LuAlONX:Ce, wherein: X is at least one or two or more elements selected from the group consisting of Bi, Tb, Pr, Gd, Se, Sm, Th, Ir, Sb, and As; 0.007 mass % $\leq$ N $\leq$ 5.0 mass %; Ce, Lu, and X satisfy 0.015 $\leq$ (Ce+X)/Lu by molar ratio; Al, O, and N satisfy Al/(O+N) > 5/13 by molar ratio; and X>0.

2. A light-emitting device comprising a light-emitting element and the fluorescent substance according to Claim 1.

3. An illuminator comprising the light-emitting device according to Claim 2.

**Patentansprüche**

1. Fluoreszierende Substanz, dargestellt durch die allgemeine Formel: LuAlONX:Ce, wobei: X mindestens einem oder zwei oder mehreren Elementen, ausgewählt aus der Gruppe bestehend aus Bi, Tb, Pr, Gd, Se, Sm, Th, Ir, Sb und As, entspricht; 0,007 Masse-% $\leq$ N $\leq$ 5,0 Masse-%; Ce, Lu und X, bezüglich des Molverhältnisses, 0,015 $\leq$ (Ce + X)/Lu genügen; Al, O und N, bezüglich des Molverhältnisses, Al/(O + N) > 5/13 genügen; und X > 0.

2. Lichtemittierende Vorrichtung, umfassend ein lichtemittierendes Element und die fluoreszierende Substanz nach Anspruch 1.

3. Beleuchtungsvorrichtung, umfassend die lichtemittierende Vorrichtung nach Anspruch 2.

**EP 2 937 912 B1**

**Revendications**

1. Substance fluorescente représentée par la formule générale : LuAlONX:Ce, X étant au moins un ou deux éléments ou plus, sélectionnés parmi le groupe se composant de Bi, Tb, Pr, Gd, Se, Sm, Th, Ir, Sb et As ; 0,007 % massique $\leq$ N $\leq$5,0 % massique ; Ce, Lu et X satisfaisant à 0,015 $\leq$ (Ce+X)/Lu en rapport molaire ; Al, O et N satisfaisant à Al/(0+N) > 5/13 en rapport molaire ; et X>0.

2. Dispositif émettant de la lumière comprenant un élément émettant de la lumière et la substance fluorescente selon la revendication 1.

3. Illuminateur comprenant le dispositif émettant de la lumière selon la revendication 2.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012062444 A
- JP 2009539219 T

- JP 2011119768 B

**Non-patent literature cited in the description**

- **KAZUAKI OHKUBO et al.** Absolute Fluorescent Quantum Efficiency of NBS Phosphor Standard Samples. *Journal of the Illuminating Engineering Institute of Japan,* 1999, vol. 83 (2), 87-93